# FASCICULE DE BREVET EUROPEEN

(11) **EP 4 057 789 B1**
(45) Date de publication et mention de la délivrance du brevet: **07.05.2025**
(21) Numéro de dépôt: 20894856.2
(22) Date de dépôt: 04.11.2020
(51) Int. Cl.: H05K 9/00

(54) **DISPOSITIF ET PROCÉDÉ POUR NEUTRALISER LA TRANSMISSION D'ONDES ÉLECTROMAGNÉTIQUES PAR ÉCRANTAGE AU MOYEN D'UN CONTENANT PORTEUR DE DISPOSITIFS ÉLECTRIQUES OU ÉLECTRONIQUES QUI LES PROTÈGE ÉLECTROMAGNÉTIQUEMENT ET LES REND INDÉTECTABLES ÉLECTROMAGNÉTIQUEMENT**
VORRICHTUNG UND VERFAHREN ZUR NEUTRALISIERUNG DER ÜBERTRAGUNG ELEKTROMAGNETISCHER WELLEN DURCH ABSCHIRMUNG MITTELS EINES BEHÄLTERS ZUR AUFNAHME VON ELEKTRISCHEN ODER ELEKTRONISCHEN VORRICHTUNGEN, DER DIESE ELEKTROMAGNETISCH SCHÜTZT UND ELEKTROMAGNETISCH UNAUFFINDBAR MACHT
DEVICE AND METHOD FOR NEUTRALISING THE TRANSMISSION OF ELECTROMAGNETIC WAVES BY SHIELDING, BY MEANS OF A CONTAINER FOR THE HOLDING OF ELECTRICAL OR ELECTRONIC DEVICES WHICH ELECTROMAGNETICALLY PROTECTS THE SAME AND RENDERS THEM ELECTROMAGNETICALLY UNDETECTABLE

(30) Priorité: 25.11.2019 ES 201930967
(43) Date de publication de la demande: 14.09.2022
(73) Titulaire: Pérez Santafé, Jesús, 50009 Zaragoza (ES)
(72) Inventeur: PÉREZ SANTAFÉ, Francisco, 50009 Zaragoza (ES); PÉREZ SANTAFÉ, Jesús, 50009 Zaragoza (ES)
(86) Numéro de dépôt international: PCT/ES2020/070675
(87) Numéro de publication internationale: WO 2021/105532

(56) Documents cités:
- CN-A- 103 179 849
- CN-A- 105 762 531
- CN-A- 109 586 039
- US-A1- 2013 333 937
- US-A1- 2015 201 327
- US-A1- 2015 201 327
- US-A1- 2016 212 893
- US-B1- 6 855 883

## Description

Dispositif de neutralisation de la transmission des ondes électromagnétiques par blindage électromagnétique

Secteur de la technique à laquelle appartient l'invention.

CN103179849A divulgue un sac de protection contre les signaux électromagnétiques qui comprend une couche de protection supérieure transparente et une couche de protection inférieure. US2015/201327A1 divulgue un étui de téléphone portable utilisant une couche intégrée pour empêcher les ondes électromagnétiques (signaux de téléphone portable) de passer à travers.
1.-Cette invention appartient au secteur technique de la communication électromagnétique et plus particulièrement au paragraphe H04K 3/00 Perturbation des communications; Contre-mesures [2006.01] selon la version de la Classification internationale des brevets (-2019.01-) dont le but est d'assurer la confidentialité et la vie privée de l'utilisateur dans l'utilisation des ondes électromagnétiques de télécommunications, par l'utilisation d'un type de conteneur enveloppant tout type de dispositif ou d'appareil de télécommunication, avec la virtualité que leur introduction dans ce conteneur, empêche la détection d'un tel appareil par des ondes électromagnétiques, et donc l'impossibilité de localiser cet appareil par des moyens de télédétection électromagnétique, y compris la téléphonie mobile, radiofréquences ou télécommunications par satellite, comme les systèmes GPS, Galileo ou autres, sans qu'il soit nécessaire d'éteindre cet appareil au préalable.
2.- Cette invention fait à son tour partie d'un autre secteur de la technique, à savoir le secteur des nanomatériaux connus sous le nom de "métamatériaux" et plus particulièrement celui des "métamatériaux électromagnétiques"dans la mesure où cette invention prévoit comme composant fondamental un métamatériel dont la structure physique est plus petite que la longueur d'onde du rayonnement électromagnétique utilisé par les mobiles (dont la fréquence est comprise entre 1 gigahertz et 300 gigahertz), de sorte que, comme il est bien connu scientifiquement, les unités de la structure physique de ce matériau ont une dimension inférieure à la moitié de la longueur d'onde du spectre électromagnétique de la lumière visible (-dont la longueur d'onde est inférieure à un micromètre) ou ce qui est le même, en disposant sa structure physique une dimension inférieure à la moitié de 560 nanomètres, la structure physique de ce nanomatériau permet le passage de la lumière visible ( dont la région du spectre électromagnétique visible va de 380 nanomètres à 750 nanomètres-) puisque le diamètre des pores de graphène est de 1,8 nanomètre, par ou qui permettent le passage de la lumière visible, mais ils ne permettent pas le passage des micro-ondes des téléphones portables, dont la plus grande longueur d'onde, pour des fréquences de 300 gigahertz, est de 1 millimètre.

Compte tenu de ce qui précède, cette invention basée sur ce type de métamatériaux électromagnétiques est donc liée au secteur de la Technologie des microstructures ( subclase B81 ) et en même temps au secteur de la Nanotechnologie ( subclase B82 ) étant donné qu'il concerne les nanostructures, dont la nature à nanoéchelle lui confère ces propriétés physiques exceptionnelles, en pénétrant de plein droit dans le secteur de la nanotechnologie des matériaux ou de la science des surfaces, et qui doivent donc être attribuées à la sous-zone B82K 30/00 , et à son tour à la sous-zone B82Y relative à "Utilisations ou applications spécifiques de nanostructures; mesure ou analyse de nanostructures et fabrication ou traitement de nanostructures"-, sa dentelle étant déjà plus douteuse dans la sous-zone B82B relative à "Nanostructures formées par manipulation d'atomes ou de molécules individuelles, ou fabrication ou traitement", bien que l'état de la technique en la matière relative à l'application du graphène pourrait également être liée à d'autres sous-secteurs de la technique tels que:
- La préparation du graphite, y compris le graphite modifié:C01B 31/04 , ( C01B003104 )

À son tour, il convient de noter que, puisque cette invention peut être développée non seulement avec le graphène, mais aussi avec d'autres matériaux électromagnétiques mono-éléments tels que le borophène, dans les deux cas, le secteur de la technique à imputer est celui des nanotechnologies pour les matériaux ou la science des surfaces du secteur B82 (-soit dans les sous-secteurs B82K ou B82B, soit B82Y, de sorte que le borophène, dans le pire des cas de doute, pourrait toujours être inclus dans un autre secteur plus résiduel tel que le secteur B99, de "Matières non prévues ailleurs dans la présente section"

Enfin, il convient de noter que la présente invention admet à son tour la possibilité de construire ce conteneur avec d'autres matériaux transparents tels que des cristaux, verres, ou plastiques/polymères qui peuvent être fabriqués avec la participation appropriée de nanofils métalliques à l'intérieur dans la proportion permise par le blindage électrique total , de manière à pouvoir continuer à satisfaire à cette exigence de leur infranchissabilité électromagnétique, sans perdre sa transparence optique.

C'est pourquoi la présente invention peut en outre couvrir les secteurs suivants:
- B29 : Travail des matières plastiques; Travail des substances à l'état Plastique en général
- B32 : Produits stratifiés
- B33:Technologie de fabrication additive ( 2005.01)

État de la technique :
La présente invention, basée sur la création de ce type de conteneurs construits à partir de ces nouveaux métamatériaux électromagnétiques transparents, constitue une innovation dans l'état actuel de la technique, tant dans le secteur concret de la "Perturbation des communications; Contre-mesures", (-H04K 3/00 de la C.I.P.-), comme dans le secteur de la Technologie des microstructures (sous-classe B81) et en même temps avec le secteur de la Nanotechnologie (sous-classe B82) et plus particulièrement dans le sous-secteur de la nanotechnologie des matériaux ou de la science des surfaces (sous-zone B82K 30/00) et dans le sous-secteur B82Y "Utilisations ou applications spécifiques de nanostructures; mesure ou analyse de nanostructures et fabrication ou traitement de nanostructures"-, et même dans le sous-secteur B82B relatif à "Nanostructures formées par manipulation d'atomes ou de molécules individuelles, ou par fabrication ou traitement".

Explication de l'invention :
Cette invention se base sur les nanomatériaux appelés "métamatériaux électromagnétiques" en prévoyant comme composant fondamental un métamatériel dont la structure physique est plus petite que la longueur d'onde des rayonnements électromagnétiques utilisés par les mobiles (dont la fréquence est habituellement comprise entre 1 gigahertz et 300 gigahertz), tandis que les unités de la structure physique de ce matériau ont une dimension inférieure à la longueur d'onde du spectre visible de la lumière (-dont la longueur d'onde est inférieure à un micromètre, ou ce qui est le même-560 nanomètres) par conséquent, ce métamatériau est à son tour transparent, pour lequel, et afin de permettre le passage de la lumière du soleil avec une certaine fluidité, les unités de sa structure physique ne doivent pas dépasser la moitié ou moins de sa longueur d'onde, de sorte que la structure physique de ces unités ne doit pas dépasser 280 nanomètres.

C'est pourquoi la propriété inventive (ou activité inventive-) de ce nouveau type de conteneur, consiste en la création d'une "cage de Faraday" "transparente" car, en plus d'agir ce conteneur comme un revêtement conducteur de l'électricité qui empêche le passage à son intérieur d'ondes électromagnétiques, (en évitant ainsi tout type de "bruit électronique" à l'intérieur), il est en outre transparent, constituant ainsi la première "cage de Faraday" transparente de l'Histoire, en disposant de ces nouveaux métamatériaux d'une structure atomique qui ne permet pas le passage des ondes électromagnétiques mais qui permet le passage de la lumière du spectre visible -dont les radiations électromagnétiques couvrent une longueur d'onde de 10 ⁽¹⁵⁾ (à savoir de 380 nm à 750 nm) lorsque la fréquence d'onde est comprise entre 400 et 790 térahertz

Par conséquent, cette invention est une nouveauté par rapport à l'état de la technique actuelle, puisque le plus proche de cette invention est le brevet européen EP 2928100 consistant en un "Dispositif et méthode pour neutraliser l'impact d'un signal d'interférence sur un satellite" ( transposition du brevet espagnol ES 2 699 736 T3-) qui consiste essentiellement en:
"d'un dispositif et d'une méthode permettant de lutter contre les interférences intentionnelles et non intentionnelles du sol de sorte que le service puisse être rétabli au niveau du satellite tout en maintenant l'utilisation sans modification des stations de réception au sol de l'utilisateur standard. Par conséquent, la solution ne se limite pas aux interférences intentionnelles et peut être appliquée à toute interférence considérée comme un bruit significatif sur le signal

Le problème technique à résoudre est le risque qui menace actuellement la confidentialité et la vie privée des utilisateurs de téléphonie mobile, lorsque les communications des tiers sont interceptées par des systèmes informatiques ou électromagnétiques.

Face à cela, le but de cette invention est de garantir la confidentialité et la vie privée de l'utilisateur au moyen d'un dispositif et d'une méthode qui neutralise l'impact des ondes électromagnétiques par un blindage à travers un conteneur porteur d'appareil de télécommunication qui rend ce dernier indétectable électromagnétiquement,

Cette invention consiste en un conteneur composé d'une ou de plusieurs parties construites avec un métamatériel électromagnétique transparent, dont la fermeture hermétique -ou l'assemblage hermétique de ses diverses parties- provoquant l'isolement de l'appareil de télécommunication introduit à l'intérieur de celui-ci, en empêchant le passage des ondes électromagnétiques utilisées par ces appareils, tant à travers les éléments qui le composent, comme à travers la zone de contact ou de fermeture de leurs parties respectives.

L'un des nouveaux "métamatériaux transparents" avec lesquels cette invention peut être construite, est le graphène, qui consiste simplement en une disposition bidimensionnelle monocouche d'atomes de carbone d'un atome d'épaisseur, qui permet de protéger l'intérieur de ce conteneur d'interférences ou d'ondes électromagnétiques, étant donné que la disposition bidimensionnelle spécifique de ses atomes de carbone confère à cette surface une faculté de captage ou de blindage d'ondes de différentes fréquences ayant une conductivité électrique élevée à la surface, et ce graphène peut être beaucoup plus stable en appliquant ses nanoparticules à la surface sur des polymères communs, de type PET, comme moyen le plus pratique d'exécuter la présente invention. Enfin, il convient de noter que, contrairement à l'oxynitrure d'aluminium (qui est construit par un processus de "nanostructuration" de nanoparticules métalliques ou de "nanofils"-) face à cela, ces nouveaux métamatériaux électromagnétiques tels que le graphène ou le borophène se distinguent de cet oxynitrure d'aluminium par le fait que leur structure physique est composée d'une disposition bidimensionnelle monocouche d'atomes, d'une largeur d'un atome, par conséquent, bien qu'ils partagent des propriétés avec l'oxynitrure d'aluminium comme sa supraconductivité électrique, ou même le fait d'être transparents, cependant ces nouveaux matériaux se différencient de cet oxynitrure d'aluminium en ce que tant le graphène que le borophène ne permettent pas le passage des ondes électromagnétiques utilisées par ces appareils de télécommunications, par la structure physique particulaire de ces nouveaux métamatériaux, empêchant ainsi le passage de ces ondes.

Description succincte du contenu des dessins:

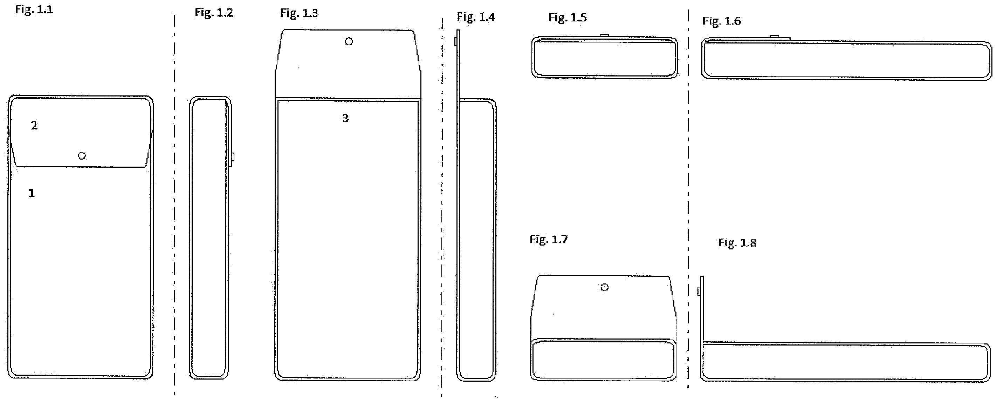

-Figure 1.1 : Vue de face du dispositif conteneur, fermé, en position verticale (levée )
-Figure 1.2 : Vue latérale du dispositif conteneur, fermé, en position verticale (levée )
-Figure 1.3 : Vue de face du dispositif conteneur, ouverte, en position verticale (levée )
-Figure 1.4 : Vue latérale du dispositif conteneur, ouvert, en position verticale (levée )
-Figure 1.5 : Vue supérieure du dispositif conteneur , fermé, en position verticale (levée )
-Figure 1.6 : Vue latérale du dispositif conteneur, fermé, en position horizontale couchée
-Figure 1.7 : Vue supérieure du dispositif conteneur, semi-ouvert, en position verticale (levée )
-Figure 1.8 : Vue latérale du dispositif conteneur, semi-ouvert, en position horizontale couchée

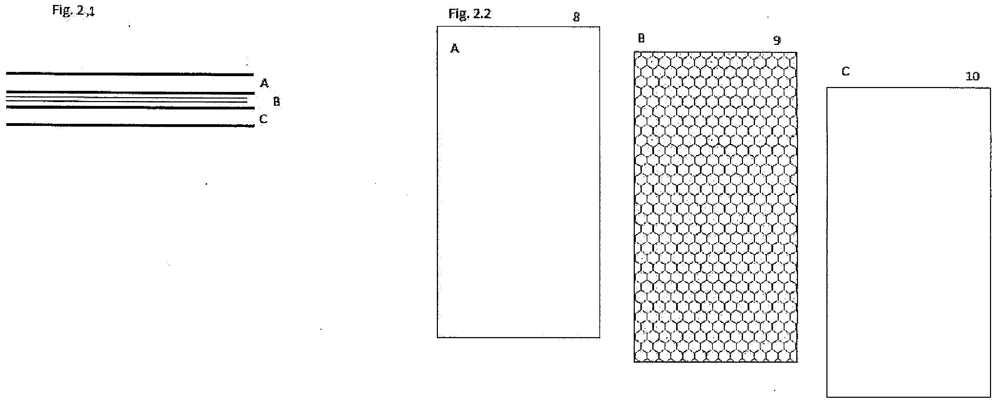

-Figure 2.1 : Découpe de l'une des parois du conteneur, indicative des trois feuilles de différents matériaux transparents qui composent ce mur .
-Figure 2.2: Décomposition des trois lames qui composent chaque paroi de ce conteneur:-Feuille A: polymère transparent extérieur; -Feuille B:graphène; -Feuille C: polymère transparent intérieur

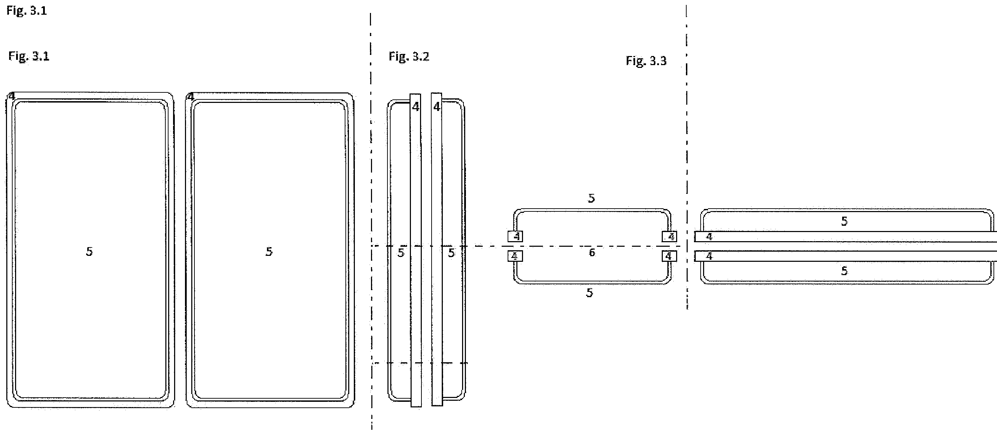

-Figure 3.1 : Vue frontale des deux boîtiers constituant le conteneur alternatif au conteneur mono-corps de la figure 1,
Figure 3.2 : Vue latérale des deux boîtiers constituant le conteneur alternatif au conteneur mono-corps susmentionné
Figure 3.3: Coupe verticale de la jonction des deux boîtiers en position horizontale

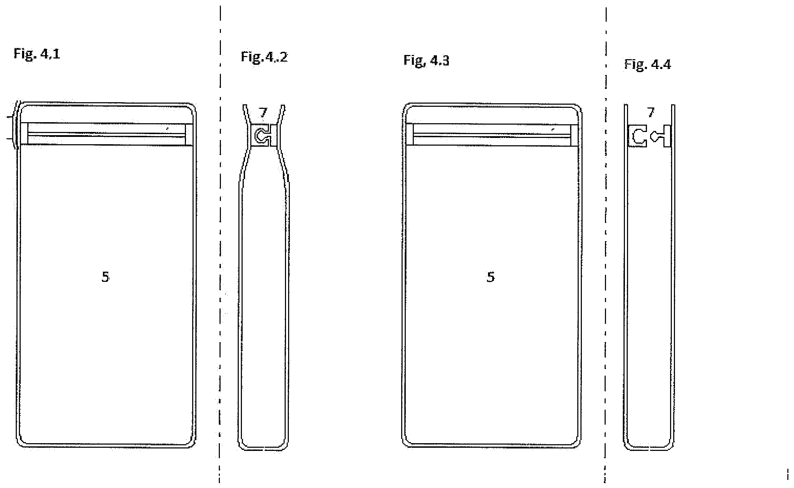

Figure 4.1 : Système de fermeture par lames longitudinales en plastique auto-encastrables type "zip" en mode fermé, en positions avant et latérale (-élevé-)
Figure 4.2 : Système de fermeture par lames longitudinales en plastique auto-encastrables type "zip" en mode ouvert, en positions avant et latérale (-élevé)

Numérotation des éléments techniques de l'invention :
1.-Corps de prisme rectangulaire -arrondi dans ses angles, qui forme le conteneur mono-corps destiné à réceptionner le mobile.
2.-Languette-patte de rabat située dans la partie supérieure du corps de prisme rectangulaire susmentionné.
3.-Zone de jonction hermétique de la languette avec le mono-corps -ou conteneur- auquel elle est attachée.
4.-Bord extérieur aimanté de chaque boîtier destiné à la liaison magnétique avec l'autre boîtier.
5.-Boîtiers dont l'assemblage constitue le conteneur alternatif au conteneur mono-corps.
6.-Zone interne destinée à l'hébergement du téléphone entre les deux boîtiers de liaison magnétique
7.-Fermeture par le système de lames longitudinales en plastique auto-ajustables type "zip".
8.-Feuille A : polymère transparent extérieur.
9.-Planche B : graphène.
10.-Feuille C : polymère transparent intérieur

Description détaillée du mode de réalisation de l'invention.

Pour permettre l'exécution de l'invention en question, il convient d'indiquer que, s'agissant de la simple construction d'un dispositif conteneur qui n'a pas besoin d'être équipé d'un mécanisme complexe, (-puisqu'il s'agit de construire une sorte de "cage de Fàraday" transparente-), il suffit d'indiquer que, pour son exécution, il suffira de faire en sorte que la structure principale de l'invention, (-qui n'est autre que le film lui-même ou les lames monocouches d'atomes de carbone destinées à envelopper ledit appareil de téléphonie) soient suffisamment rapprochées les unes des autres par le contact physique entre les différentes zones de coupe de chaque lame, afin de pouvoir recouvrir ces feuilles par l'injection de polymères transparents sur les deux faces, avec la particularité que, s'agissant d'une très fine feuille, une grande précision est requise, (à la fois pour les opérations de couverture des faces supérieure et inférieure de ces feuilles au moyen de ce polymère et pour les opérations de liaison des zones de coupe de chaque feuille), de manière à assurer l'étanchéité entre ces lames, pour assurer l'infranchissabilité des ondes électromagnétiques à travers les parois de ce conteneur porta-téléphone, pour la réalisation duquel il conviendra de recourir à des équipements d'une précision suffisante au moment de leur assemblage.

Indication de la manière dont l'invention est susceptible d'application industrielle.

Enfin, cette invention, s'agissant de la simple construction d'un dispositif conteneur, son exécution peut se faire selon les techniques qui existent déjà dans l'industrie de l'injection de polymères,et le problème de l'acquisition de "feuilles monocouches d'atomes de carbone",- telles que le graphène, etc. - étant donné, que leur vente est déjà généralisée sur le marché de la fabrication de ces métamatériaux, on peut conclure qu'il suffira de couvrir ces "feuilles monocouches d'atomes" par les opérations d'injection de polymères transparents susmentionnées des deux côtés de chaque feuille, en évitant que, s'agissant d'une fine couche de ce type de métamatériaux, au moment de l'assemblage des extrémités de ces feuilles, l'utilisation d'appareils visuels de haute précision est requise pour assurer l'infranchissabilité des ondes électromagnétiques à travers les parois de ce conteneur.

## Revendications

1. "Dispositif pour neutraliser l'impact des ondes électromagnétiques par blindage à travers un conteneur porteur d'un appareil de télécommunication rendant ce dernier indétectable électromagnétiquement, consistant en un conteneur constitué d'une ou de plusieurs parties construites avec un métamatériel électromagnétique transparent, où le métamatériel est constitué de graphène ou de borophène de sorte que la structure physique de ces unités ne doit pas dépasser 280 nm où fermeture hermétique ou la liaison hermétique de la ou des différentes parties provoquent l'isolement de l'appareil de télécommunication introduit en son sein en empêchant le passage des ondes électromagnétiques utilisées par l'appareil de télécommunication, à travers les parois du conteneur et à travers la zone de fermeture ou de liaison de la ou des différents parties respectives.

2. Dispositif selon la revendication 1 où le conteneur est construit de manière à permettre à l'utilisateur de visualiser l'écran complet de l'appareil de télécommunication.»

## Patentansprüche

1. "Eine Vorrichtung zum Neutralisieren der Auswirkungen elektromagnetischer Wellen durch Abschirmung durch einen Behälter, der ein Telekommunikationsgerät enthält, wodurch dieses elektromagnetisch nicht erkennbar wird, bestehend aus einem Behälter, der aus einem oder mehreren Teilen besteht, die aus einem transparenten elektromagnetischen Metamaterial aufgebaut sind, wobei das Metamaterial aus Graphen oder Borophen besteht, so dass die physikalische Struktur dieser Einheiten 280 nm nicht überschreiten darf, wobei der hermetische Verschluss oder die hermetische Verbindung des oder der verschiedenen Teile die Isolierung des darin eingeführten Telekommunikationsgeräts bewirkt, indem der Durchgang der vom Telekommunikationsgerät verwendeten elektromagnetischen Wellen durch die Wände des Behälters und durch den Verschluss- oder Verbindungsbereich des oder der jeweiligen verschiedenen Teile verhindert wird."

2. Ein Gerät nach Anspruch 1, wobei der Container so konstruiert ist, dass er dem Benutzer die Anzeige des gesamten Bildschirms des Telekommunikationsgeräts ermöglicht.

## Claims

1. "Device for neutralizing the impact of electromagnetic waves by shielding through a container carrying a telecommunications device making the latter electromagnetically undetectable, consisting of a container made up of one or more parts constructed with a transparent electromagnetic metamaterial, where the metamaterial is made up of graphene or borophene so that the physical structure of these units must not exceed 280 nm, where the hermetic closure or hermetic connection of the different part or parts causes the isolation of the telecommunications device introduced therein by preventing the passage of the electromagnetic waves used by the telecommunications device, through the walls of the container, and through the closure or connection area of he respective different part or parts."

2. A device according to claim 1 wherein the container is constructed so as to allow the user to view the full screen of the telecommunications device."
